# EUROPEAN PATENT SPECIFICATION

(11) **EP 2 516 689 B1**
(45) Date of publication and mention of the grant of the patent: **18.04.2018**
(21) Application number: 10798669.7
(22) Date of filing: 16.12.2010
(51) Int. Cl.: C23C 10/02, C23C 10/48, C23C 10/52, C23C 14/16, C23C 14/32, C23C 28/00, C23C 14/58

(54) **METHODS OF FORMING NICKEL ALUMINIDE COATINGS**
VERFAHREN ZUR HERSTELLUNG VON BESCHICHTUNGEN AUF NICKELALUMINID
PROCÉDÉ DE FABRICATION DE REVÊTEMENTS EN ALUMINURE DE NICKEL

(30) Priority: 30.06.2010 US 827938; 21.12.2009 US 288711 P; 30.06.2010 US 827920; 21.12.2009 US 288707 P
(43) Date of publication of application: 31.10.2012
(73) Proprietor: General Electric Company, Schenectady, NY 12345 (US)
(72) Inventor: HAZEL, Brian, Thomas, Cincinnati OH 45215 (US); LIPKIN, Don, Mark, Niskayuna NY 12309 (US); RUCKER, Michael, Howard, Cincinnati OH 45215 (US); VIGUIE, Rudolfo, Cincinnati OH 45215 (US)
(74) Representative: Foster, Christopher Michael
(86) International application number: PCT/US2010/060702
(87) International publication number: WO 2011/084573

(56) References cited:
- EP-A1- 1 652 959
- EP-A1- 1 652 968
- EP-A1- 1 944 387
- US-A- 5 773 748
- US-A1- 2004 157 081
- US-A1- 2005 132 717

## Description

### BACKGROUND OF THE INVENTION

This invention relates generally to coatings for metallic substrates, and more specifically to processes for providing nickel aluminide-based coatings on metallic substrates.

Processes for providing NiAl type coatings are discussed in U.S. Patents 6,620,524 and; 6,933,058 and US Patent Publication, 20070207339. Exemplary processes to provide a NiAl based overlay coating include cathodic arc (ion plasma) deposition techniques using sources having a generally homogenous composition. This process results in uniform chemistry through the coating thickness, but can lead to defects in the coating associated with macroparticle transfer and subsequent shadowing. Discussion of macroparticles from cathodic arc processing may be found in A. Anders, "Cathodic Arcs: From Fractal Spots to Energetic Condensation", Springer (2008).

The cathodic arc deposited NiAl coatings may suffer from macroparticles that are believed to reduce oxidation performance. Additionally, the consumable source (i.e., cathode) used in the deposition process is difficult to manufacture due to the high melting temperature, large freezing range, and low ductility (i.e., brittleness) of the NiAl material.

U.S. Patent No. 6,964,791 discloses a two-step method for supplying a coating onto a metallic substrate. The method includes disposing a first coating layer onto said substrate comprising nickel, zirconium, and aluminum, and thereafter, disposing onto the first coating layer, a second coating layer comprising at least 90 atomic percent aluminum. Subsequent processing leads to the formation of a substantially single-phase reacted coating layer comprising nickel aluminide with a B2 structure. The reacted coating layer includes a higher aluminum concentration at the outer surface and a lower aluminum concentration near the coating/substrate interface.

The teachings of U.S. Patent 6,964,791 demonstrate that substantially pure aluminum deposited over NiAl(CrZr) coating layer exhibits high interdiffusion when heated to 1079 °C (1975 °F), thus covering the macroparticles mentioned above. However, the coating exhibits a higher aluminum surface level and an aluminum compositional gradient throughout the thickness of the coating.

Further improvements in coatings and coating processes are still sought, in particular, to reduce costs, ease manufacturing difficulties, and shorten coating times. In addition, improvements in alloying capabilities are sought due to the brittle nature of NiAl materials.

EP 1944387 A1 relates to a system and method for the restoration or regeneration of an article (such as a turbine blade or vane for a gas turbine engine). US 2004/157081 A1 relates to a method for providing an article with an oxidation-resistant coating. EP 1652959 A1 relates to a method for depositing gamma-prime nickel aluminide coatings. EP 1652968 A1 relates to coating systems containing beta phase and gamma-prime phase nickel aluminide. US 2005/0132717 A1 discloses a coating system with a precursor which has an aluminum top layer disposed on a NiPt layer. US 6 964 791 relates to a coated article comprising a metallic substrate and a substantially single-phase coating disposed on the substrate, wherein the coating comprises nickel and at least about 30 atomic percent aluminum.

### BRIEF DESCRIPTION OF THE INVENTION

The above-mentioned need or needs may be met by exemplary embodiments, which provide a method for forming a nickel aluminide based coating on a metallic substrate.

The present invention provides a method in accordance with claim 1 herein.

further aspects of the method of the invention are provided in accordance with claims 2-5 herein.

The coating precursor layers are disposed with sufficient relative thicknesses, so that following subsequent processing a nickel aluminide based coating may be provided on a metallic substrate.

Separation of a significant portion of the aluminum from the remainder of the coating composition in the consumable cathodes eliminates the difficulties associated with brittle NiAl cathodes.

### BRIEF DESCRIPTION OF THE DRAWINGS

The subject matter, which is regarded as the invention, is particularly pointed out and distinctly claimed in the concluding part of the specification. The invention, however, may be best understood by reference to the following description taken in conjunction with the accompanying drawing figures in which:
FIG. 1 is a schematic cross-sectional representation of a metallic substrate having an exemplary coating precursor disposed thereon.
FIG. 2 is a schematic cross-sectional representation of the metallic substrate of FIG. 1 having an exemplary coating disposed thereon.
FIG. 3 is a flowchart illustrating an exemplary process for forming a coating in accordance with embodiments disclosed herein.

### DETAILED DESCRIPTION OF THE INVENTION

Exemplary embodiments are described herein with reference to the figures. In general terms, an exemplary coating is disposed on a metallic substrate by supplying the desired coating composition in at least two parts to provide a coating precursor. Subsequent processing of the coating precursor provides the desired coating.

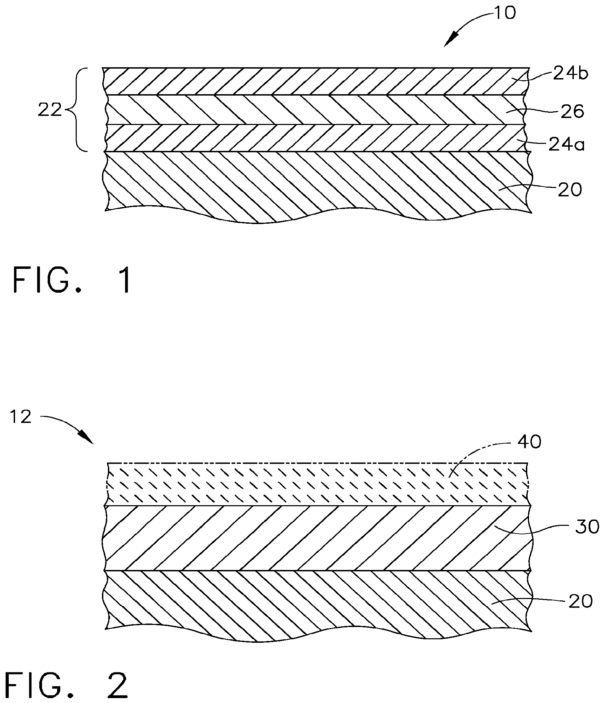

FIG. 1 shows an exemplary article 10 including a substrate 20 having a layered coating precursor 22 disposed thereon. In an exemplary embodiment, coating precursor 22 includes at least one layer 24a comprised of a nickel alloy (NiX), a layer 26 comprised substantially of aluminum, and a layer 24b also comprised of the nickel alloy (NiX). In the illustrated embodiment, layer 26 is disposed between layers 24a and 24b. Additional layers (NiX or aluminum) may be provided as well to provide a suitable coating precursor 22. In other exemplary embodiments, the coating precursor can include a NiX layer 24a and aluminum layer 26 to meet the requirements of the desired coating.

The coating composition, prior to deposition, is separated into at least two portions, and provided through separate "consumables", i.e., cathodes for cathodic arc (ion plasma) deposition. The portions of the coating composition provided by the consumable are very different in composition. One portion is substantially pure aluminum (i.e., aluminum source), and the other portion is nickel plus other alloying elements (i.e., NiX source). For example, the other alloying elements may include those elements desired for environmental resistance, strengthening, and the like, and theoretically may be substantially free of aluminum. For example, in addition to nickel, the second portion may include alloying elements such as chromium, zirconium, hafnium, silicon, yttrium, or combinations thereof. Additional alloying elements may include titanium, tantalum, rhenium, lanthanum, cerium, calcium, iron, gallium, and the like to provide desired characteristics in the final coating. The second portion is designated as "NiX" herein, where X represents any one or more alloying elements.

In other exemplary embodiments, the other portion (i.e., NiX) may include some aluminum content at reduced levels as compared to prior consumables and less than an aluminum content that would be required absent the first source of aluminum. The reduced aluminum in the NiX source will still provide the desired ease of manufacturing and provide aluminum diffusion to heat macroparticles, etc. Provision of some of the required aluminum content in the NiX portion reduces the amount of aluminum from the first portion aluminum source) needed to reach the target composition, thus providing process flexibility.

The coating composition is disposed onto the substrate through a multi-layering cathodic arc (ion plasma) deposition process. Subsequent processing and/or heat treatment are utilized to provide a dense coating wherein at least the aluminum is distributed throughout the coating thickness, rather than presenting a higher aluminum content at the surface. Preferably, the coating comprises a substantially uniform distribution of the alloying elements. In an exemplary embodiment, a three layer coating process is utilized. A first layer may utilize the NiX consumable, followed by deposition of Al, and thereafter, another NiX layer. The thickness of each deposited layer is dependent upon the desired final coating composition. The layered coating precursor may be subjected to a homogenization heat treatment at a predetermined temperature for sufficient time for the layers to interdiffuse into a dense coating. The heat treatment is performed at about 1079 °C (1975 °F).

In other exemplary embodiments, additional Al and/or NiX layers may be utilized to form the layered coating precursor, and subsequently processed to provide the desired coating. In an exemplary embodiment the layered coating precursor is provided in a sufficient thickness so that a total coating thickness is nominally between about 12.7-254 microns (about 0.5-10.0 mil). In other exemplary embodiments, the total coating thickness is between about 12.7- 76.2 microns (about 0.5-3.0 mil). The layers from each of the respective sources may be uniform in thickness, or may vary in thickness in order to achieve the desired coating.

Although described in terms of providing a layered coating precursor, those with skill in the art will appreciate that co-depositing NiX and Al would provide a coating precursor having near a infinite number of very fine layers. Thus any number of layers may be possible, as long the target composition requirements are achieved. Minimum number of layers is two: 24a and 26. Maximum number of layers can be infinite where for example NiX and Al are co-deposited at the same time making a near infinite number of very fine layers. Any number of layers in between are possible as long as the final composition requirements are achieved.]

FIG. 2 illustrates a coated article 12 including the substrate 20 and a coating 30, formed from the layered coating precursor. An optional ceramic layer 40, shown in phantom, may be included on the coated article 12.

Exemplary coating compositions disclosed herein represent target or nominal compositions obtained by disposing layers of the NiX and Al onto the substrate. Table I lists exemplary compositions of as-deposited coatings, wherein a significant amount of the aluminum portion is supplied from a first consumable source (e.g., cathode) and the remaining portion is provided through one or more additional consumable sources (e.g., cathodes). The exemplary coating compositions provided in Table I generally correspond to the coating compositions set forth in US Patent 6,153,313, incorporated herein in its entirety.

In an exemplary embodiment, the as-deposited coating, applied via at least two different consumables (e.g., A1 and NiX), includes zirconium content of at least 0.2 atomic percent in addition to nickel and aluminum. In other exemplary embodiments, the zirconium content is in the range of at 0.2 to 0.5 atomic percent, as set forth in U.S. Patent No. 6,255,001, which is incorporated herein in its entirety.

**TABLE I**

| | A | B | C |
|---|---|---|---|
| Aluminum | 30-60%* | 35-55% | 35-50% |
| Chromium | To 25% | 0.5-25% | 0.5-15% |
| Titanium | To 5% | 0.1-5.0% | 0.1-5.0% |
| Tantalum | To 5% | 0.1-5.0% | 0.1-3.0% |
| Silicon | To 5% | 0.1-5.0% | 0.1-2.0% |
| Calcium | To 1% | 0.01-1.0% | 0.01-1.0% |
| Hafnium | To 2% | 0.01-2.0% | 0.01-2.0% |
| Iron | To 1% | 0.02-0.5% | 0.02-0.5% |
| Yttrium | To 1% | 0.01-1.0% | 0.01-1.0% |
| Gallium | To 0.5% | 0.02-0.2% | 0.02-0.2% |
| Zirconium | To 0.5% | 0.01-0.5% | 0.01-0.5% |
| Nickel | Balance | Balance | Balance |
| *All values given in atomic percent of an as-deposited coating | | | |

In an exemplary embodiment, the as-deposited coating, applied via at least two different consumables (e.g., Al and NiX), includes a chromium content in a range of about 2 to 15 atomic percent, and a zirconium content of about 0.1 to 1.2 atomic percent, the balance nickel as set forth in U.S. Patent No. 6,291,084, incorporated herein in its entirety. The balance includes an aluminum content of about 30 to 60 atomic percent of the as-deposited coating, preferably about 30 to 50 atomic percent, and more preferably an atomic ratio of 1:1 with the nickel content.

In an exemplary embodiment, the as-deposited coating, applied via at least two different consumables (e.g., A1 and NiX), includes aluminum, nickel, and at least two modifying elements selected from zirconium, hafnium, yttrium, and silicon. In an exemplary embodiment, zirconium is at least one of the selected modifying elements. In an exemplary embodiment, the modifying elements, if present, may comprise from about 0.1 to about 5, more preferably from about 0.1 to about 3, and most preferably from about 0.1 to about 1, percent by weight of the as-deposited coating composition. In an exemplary embodiment, yttrium, when present, is included in an amount of from about 0.1 to about 1 percent by weight of the as-deposited coating. Exemplary coating compositions are set forth in U.S. Patent No. 6,579,627, incorporated herein in its entirety.

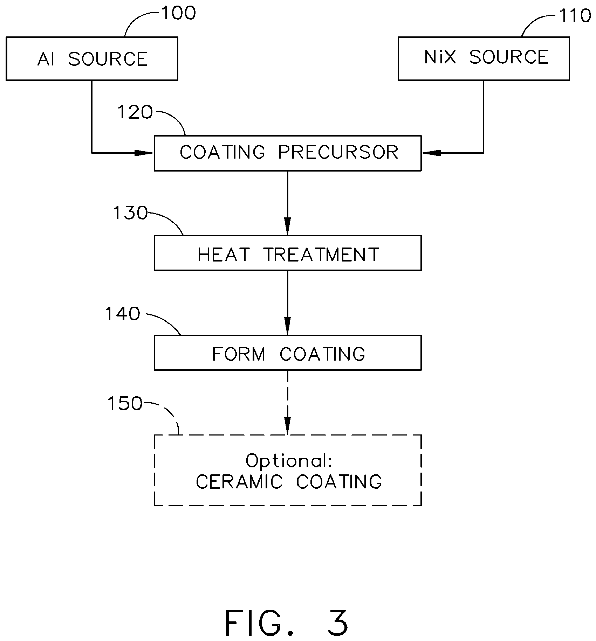

FIG. 3 illustrates and exemplary process for providing a coated article. In Step 100, an aluminum source (e.g., consumable cathode) is provided. In step 110, a nickel alloy (NiX) source (e.g., consumable cathode) is provided. The aluminum and NiX are provided on a substrate surface in the form of a layered coating precursor in Step 120. The substrate/coating precursor undergo subsequent processing, such as a heat treatment (Step 130) under sufficient time and temperature conditions to form a nickel aluminide coating on the substrate (Step 140).

The exemplary coatings disclosed herein may be particularly suitable for use as bond coats disposed between a substrate and an overlying thermal barrier coating, for example, 7 YSZ, as illustrated by optional Step 150. Alternately, the exemplary coatings disclosed herein may be suitable for use as environmental coatings (without an overlying thermal barrier coating) as will be appreciated by those having skill in the relevant art. Exemplary metallic substrates include nickel base superalloys, cobalt base superalloys, and iron base superalloys.

Thus, with appropriate thicknesses of deposited layers, and subsequent processing (e.g., diffusion heat treatment), a nickel aluminide based coating may be provided on a metallic substrate. Separating a significant portion of the aluminum from the remainder of the coating composition as disclosed herein eliminates the difficulties associated with brittle NiAl cathodes, eases manufacturing difficulties, and shortens coating times.

This written description uses examples to disclose the invention, including the best mode, and also to enable any person skilled in the art to make and use the invention. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method comprising:
providing a first source (100) able to supply aluminum content for a nickel aluminide based coating (30);
providing a second source (110) able to supply nickel and at least one alloy element content for the nickel aluminide based coating;
providing a metallic substrate (20);
disposing (120) by a cathodic arc deposition process a nickel aluminide based coating precursor (22) on at least a portion of the metallic substrate, the coating precursor comprising aluminum content (26) provided by the first source, and nickel and at least one alloy element (24a, 24b) content provided by the second source; the process comprising:
disposing a first layer (24a) of the coating precursor (22) comprising an amount of nickel and at least one alloy element (24a) to overlie and be in contact with the metallic substrate (20) utilizing the second source (110); thereafter
disposing an intermediate layer (26) of the coating precursor (22) comprising an amount of aluminum (26) to overlie and be in contact with the first layer (24a) utilizing the first source (100); and thereafter
disposing a second layer (24b) of the coating precursor (22) of nickel and at least one alloy element in contact with and overlying the intermediate aluminum layer (26) utilizing the second source (110);
the method further comprising forming (140) the nickel aluminide based coating (30) from the coating precursor (22), wherein the forming comprises subjecting the coating precursor (22) to a heat treatment so as to interdiffuse the layers (24a,26,24b) to form the nickel aluminide based coating wherein the aluminum is diffused throughout a thickness of the coating, wherein the heat treatment includes heating to 1079°C (1975°F).

2. The method according to claim 1, wherein either or both of first source and second source (100, 110) comprise a consumable cathode for use in a cathodic arc deposition technique.

3. The method according to claim 1, wherein providing the second source (110) includes providing at least one alloy element selected from the group consisting of chromium, zirconium, hafnium, silicon, yttrium, titanium, tantalum, rhenium, lanthanum, cerium, calcium, iron, gallium, and combinations thereof.

4. The method according to claim 1, wherein disposing the coating precursor (22) includes disposing sufficient nickel and at least one alloy and aluminum in sufficient quantities so that the nickel aluminide based coating has a coating thickness of between 12.7-254 microns, inclusive.

5. The method according to claim 1, further comprising:
disposing a thermal barrier ceramic layer (150) overlying the nickel aluminide based coating.

## Patentansprüche

1. Ein Verfahren, umfassend:
Bereitstellen einer ersten Quelle (100), die einer nickelaluminidbasierten Beschichtung (30) Aluminiumgehalt zuführen kann;
Bereitstellen einer zweiten Quelle (110), die der nickelalumidbasierten Beschichtung Nickel und mindestens einen Legierungselementgehalt zuführen kann;
Bereitstellen eines metallischen Substrats (20);
Anordnen (120), durch einen kathodischen Lichtbogenabscheidungsprozess, eines nickelalumidbasierten Beschichtungsvorläufes (22) auf mindestens einen Teil des metallischen Substrats, wobei der Beschichtungsvorläufer einen Aluminiumgehalt (26) umfasst, der durch die erste Quelle bereitgestellt wird, und Nickel und mindestens ein Legierungselementgehalt (24a, 24b) durch die zweite Quelle bereitgestellt werden, wobei der Prozess umfasst:
Anordnen einer ersten Schicht (24a) des Beschichtungsvorläufers (22), der eine Nickelmenge und mindestens ein Legierungselement (24a) umfasst, um durch Benutzen der zweiten Quelle (110) über dem metallischen Substrat (20) zu liegen und in Kontakt damit zu sein; danach
Anordnen einer Zwischenschicht (26) des Beschichtungsvorläufers (22), der eine Aluminiummenge (26) umfasst, um durch Benutzen der ersten Quelle (100) über der ersten Schicht (24a) zu liegen und in Kontakt damit zu sein; und danach Anordnen einer zweiten Schicht (24b) des Beschichtungsvorläufers (22) aus Nickel und mindestens einem Legierungselement in Kontakt mit der Zwischenaluminiumschicht (26) durch Benutzen der zweiten Quelle (110);
wobei das Verfahren ferner das Formen (140) der auf nickelaluminidbasierten Beschichtung (30) aus dem Beschichtungsvorläufer (22) umfasst, wobei das Formen das Unterziehen des Beschichtungsvorläufers (22) einer Wärmebehandlung zum Interdiffundieren der Schichten (24a, 26, 24b) zum Formen der nickelaluminidbasierten Beschichtung umfasst, wobei das Aluminium durch eine gesamte Dicke der Beschichtung diffundiert wird, wobei die Wärmebehandlung das Erwärmen auf 1079°C (1975°F) umfasst.

2. Das Verfahren nach Anspruch 1, wobei entweder die erste Quelle oder die zweite Quelle (100, 110) oder beide eine verbrauchbare Kathode zur Verwendung in einer Kathodenlichtbogen-Ablagerungstechnik umfassen.

3. Das Verfahren nach Anspruch 1, wobei das Bereitstellen der zweiten Quelle (110) das Bereitstellen mindestens eines Legierungselements beinhaltet, das ausgewählt ist aus der Gruppe bestehend aus Chrom, Zirkonium, Hafnium, Silizium, Yttrium, Titan, Tantal, Rhenium, Lanthan, Cer, Calcium, Eisen, Gallium und Kombinationen davon.

4. Das Verfahren nach Anspruch 1, wobei das Anordnen des Beschichtungsvorläufers (22) das Anordnen von ausreichend Nickel und mindestens einer Legierung und Aluminium in ausreichenden Mengen beinhaltet, damit die nickelalumidbasierte Beschichtung eine Beschichtungsdicke zwischen einschließlich 12,7 bis 254 Mikrometer aufweist.

5. Das Verfahren nach Anspruch 1, ferner umfassend:
Anordnen einer Wärmesperrkeramikschicht (150), die über der nickelaluminidbasierten Beschichtung liegt.

## Revendications

1. Procédé comprenant :
la fourniture d'une première source (100) capable d'apporter de l'aluminium entrant dans la composition d'un revêtement à base d'aluminiure de nickel (30) ;
la fourniture d'une deuxième source (110) capable d'apporter du nickel et au moins un élément d'alliage entrant dans la composition du revêtement à base d'aluminiure de nickel ;
la fourniture d'un substrat métallique (20) ;
la disposition (120) en utilisant un procédé de dépôt par arc cathodique d'un précurseur de revêtement à base d'aluminiure de nickel (22) sur au moins une partie du substrat métallique, le précurseur de revêtement comprenant de l'aluminium (26) apporté par la première source, et comprenant du nickel et au moins un élément d'alliage (24a, 24b) apportés par la deuxième source ; le procédé comprenant :
la disposition d'une première couche (24a) du précurseur de revêtement (22) comprenant une quantité de nickel et d'au moins un élément d'alliage (24a) destinée à recouvrir et à se trouver en contact avec le substrat métallique (20) en utilisant la deuxième source (110) ; et ensuite
la disposition d'une couche intermédiaire (26) du précurseur de revêtement (22) comprenant une quantité d'aluminium (26) destinée à recouvrir et à se trouver en contact avec la première couche (24a) en utilisant la première source (100) ; et ensuite
la disposition d'une deuxième couche (24b) du précurseur de revêtement (22) de nickel et d'au moins un élément d'alliage en contact avec et recouvrant la couche intermédiaire d'aluminium (26) en utilisant la deuxième source (110) ;
le procédé comprenant en outre la formation (140) du revêtement à base d'aluminiure de nickel (30) à partir du précurseur de revêtement (22), la formation comprenant le fait de soumettre le précurseur de revêtement (22) à un traitement thermique afin d'interdiffuser les couches (24a, 26, 24b) pour former le revêtement à base d'aluminiure de nickel, l'aluminium étant diffusé à travers une épaisseur du revêtement, le traitement thermique comprenant un chauffage à 1 079 °C (1 975 °F).

2. Procédé selon la revendication 1, dans lequel l'une ou l'autre de la première source et de la deuxième source (100, 110), ou les deux, comprennent une cathode consommable destinée à une utilisation dans une technique de dépôt par arc cathodique.

3. Procédé selon la revendication 1, dans lequel la fourniture de la deuxième source (110) comprend la fourniture d'au moins un élément d'alliage sélectionné dans le groupe constitué du chrome, du zirconium, du hafnium, du silicium, de l'yttrium, du titane, du tantale, du rhénium, du lanthane, du cérium, du calcium, du fer, du gallium, et de combinaisons de ceux-ci.

4. Procédé selon la revendication 1, dans lequel la disposition du précurseur de revêtement (22) comprend la disposition d'une quantité suffisante de nickel et d'au moins un alliage et d'aluminium en quantités suffisantes de telle sorte que le revêtement à base d'aluminiure de nickel ait une épaisseur de revêtement de 12,7 à 254 microns, inclusivement.

5. Procédé selon la revendication 1, comprenant :
la disposition d'une barrière thermique en céramique (150) recouvrant le revêtement à base d'aluminiure de nickel.
